(19) Europäisches Patentamt / European Patent Office / Office européen des brevets

(11) **EP 4 163 112 A1**

(12) **EUROPEAN PATENT APPLICATION**
published in accordance with Art. 153(4) EPC

(43) Date of publication:
**12.04.2023 Bulletin 2023/15**

(21) Application number: **21817921.6**

(22) Date of filing: **25.05.2021**

(51) International Patent Classification (IPC):
*B32B 27/36* (2006.01)  *C08J 5/18* (2006.01)
*H01L 21/301* (2006.01)  *C09J 7/25* (2018.01)
*C09J 7/38* (2018.01)  *C08G 63/64* (2006.01)

(52) Cooperative Patent Classification (CPC):
**B32B 27/36; C08G 63/64; C08J 5/18; C09J 7/25;
C09J 7/38; H01L 21/30**

(86) International application number:
**PCT/JP2021/019791**

(87) International publication number:
**WO 2021/246239 (09.12.2021 Gazette 2021/49)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **05.06.2020 JP 2020098640**

(71) Applicant: **TOYOBO CO., LTD.**
**Osaka-shi
Osaka 5300001 (JP)**

(72) Inventor: **HAYASHIBARA Mikiya**
**Otsu-shi, Shiga 520-0292 (JP)**

(74) Representative: **Müller-Boré & Partner
Patentanwälte PartG mbB
Friedenheimer Brücke 21
80639 München (DE)**

(54) **HEAT-RESISTANT FILM**

(57) An object of the present invention is to provide a heat-resistant film that is suitable for protection of a surface provided with electrical conduction, decoration or the like in a plastic product, a glass product, a ceramic product, and the like, or that is suitable for holding a semiconductor, dies, and the like in producing dies through dicing and singulation. The film that solves the above object is a heat-resistant film comprising a thermoplastic resin, wherein (a) the thermoplastic resin is a polyester-based elastomer comprising a hard segment and a soft segment that are linked to each other, (b) the hard segment comprises a polyester unit constituted from an aromatic dicarboxylic acid and an aliphatic diol or an alicyclic diol, (c) the soft segment is constituted mainly from the prescribed polycarbonate, (d) a weight ratio of the hard segment contained in the polyester-based elastomer exceeds 50%, and (e) the film comprising the thermoplastic resin has an elastic modulus of 30 to 500 MPa, an elongation at break of 200 to 700%, and a ratio F50/F25 of 1.05 or more, the ratio F50/F25 being a ratio of a stress F50 at an elongation of 50% to a stress F25 at an elongation of 25%.

EP 4 163 112 A1

**Description**

TECHNICAL FIELD

The present invention relates to a heat-resistant film that is suitable for protection of a surface provided with electrical conduction, decoration, or the like in a plastic product, a glass product, a ceramic product, and the like, or that is suitable for, when a semiconductor and the like are cut and separated to prepare dies, holding of the semiconductor, the dies, and the like.

BACKGROUND ART

Plastic products, glass products, ceramic products, and the like may have not only a flat surface but also a curved surface, and further may have a shape with projections or depressions. Films to protect these products are required to be adaptable to various uses. For example, since an adhesive sheet having an adhesive laminated on a film is required to have followability, uniform followability in the face is required.

A semiconductor manufacturing process includes a dicing step of cutting a wafer, a substrate, and the like into dies, an expansion step of increasing spaces between dies after singulation so that the dies can be readily picked up with a suction jig or the like, and a pickup step of picking the dies up. There are various demands of a protection film, an adhesive sheet, and the like that can reduce loads in each step.

In the dicing step, an appropriate stiffness is required to (i) hold the wafer, the substrate, and the like, (ii) prevent misalignment during dicing caused by a blade or the like, and (iii) prevent dies scattering. In the expansion step, an extensibility is required so that the spaces between the dies can be increased uniformly. In some cases, improving performance by TSV (Through Silicon wafer Via) in which multiple semiconductor chips are stacked, process simplification by directly applying a sealant by transfer molding or the like, treatment of wafers at high temperatures of 150°C or higher, and the like may be conducted, and thus, a base for a surface protection film or a dicing tape is required to have heat resistance.

In particular, as the base of an adhesive sheet for the surface protection film or the dicing tape in the semiconductor manufacturing process, for example, a multilayer film characterized by laminating resin compositions containing a vinyl aromatic hydrocarbon or a hydrogenated product of a conjugated diene hydrocarbon copolymer and a polypropylene-based resin is disclosed. Such a multilayer film has sufficient expandability, but, unfortunately, bends due to the weight of a wafer, and has defects such as wrinkles and pressing marks on the base due to a heat treatment in a step of coating an adhesive layer and the like and the above-mentioned treatment at high temperature (Patent Document 1).

A polyester-based resin has a high glass transition temperature and is a material excellent in heat resistance. Such advantages of the polyester-based resin led to disclosed amorphous polyester having a controlled glass transition temperature of 0 to 50°C to gain a certain expandability. However, this polyester-based resin cannot maintain tension when expanded, resulting in deflection and the like. Further, the polyester-based resin has decreased elastic modulus at temperature exceeding the glass transition temperature.

A method for laminating a polyester-based resin having a glass transition temperature of -100 to 0°C and a polyester-based resin having a glass transition temperature of 0 to 100°C is also disclosed. However, since a film produced by this method basically includes a layer having a low melting point or a low softening point, treatment at high temperature causes defects such as wrinkles and pressing marks, and the deflection due to the weight of a wafer (Patent Documents 2 and 3).

As a polyester-based elastomer, a block copolymer in which a hard segment composed of polyester constituted from an aromatic dicarboxylic acid and an aliphatic diol or an alicyclic diol, and a soft segment composed mainly of an alicyclic diol are linked to each other is known. The block copolymer has higher heat resistance than those of a polystyrene-based elastomer, a polyolefin-based elastomer, a polyamide-based elastomer, and the like, therefore, the block copolymer is used in various applications. However, since most block copolymers has a yield point at a low elongation of 10 to 25%, elongation beyond this range makes uniform extension difficult. If the content of the soft segment is increased to solve these problems, heat resistance may be reduced, and both heat resistance and expandability cannot be achieved.

PRIOR ART DOCUMENT

PATENT DOCUMENT

Patent Document 1: JP 2009-094418 (A)
Patent Document 2: JP 2003-092273 (A)

Patent Document 3: JP 2017-034618 (A)

## SUMMARY OF THE INVENTION

### PROBLEMS TO BE SOLVED BY THE INVENTION

An object of the present invention is to provide a heat-resistant film that is suitable for protection of a surface provided with electrical conduction, decoration or the like in a plastic product, a glass product, a ceramic product, and the like, or that is suitable for holding a wafer, dies, and the like in producing dies through dicing and singulation.

### SOLUTIONS TO THE PROBLEMS

As a result of intensive studies for solving the above object, the inventors have completed the following inventions.

[1] A heat-resistant film comprising a thermoplastic resin, wherein

the thermoplastic resin is a polyester-based elastomer comprising a hard segment and a soft segment that are linked to each other,
the hard segment comprises a polyester unit constituted from (i) an aromatic dicarboxylic acid and (ii) an aliphatic diol or an alicyclic diol,
the soft segment is constituted mainly from an aliphatic polycarbonate,
a weight ratio of the hard segment contained in the polyester-based elastomer exceeds 50%, and
the film comprising the thermoplastic resin has an elastic modulus of 30 to 500 MPa, an elongation at break of 200 to 700%, and a ratio F50/F25 of 1.05 or more, the ratio F50/F25 being a ratio of a stress F50 at an elongation of 50% to a stress F25 at an elongation of 25%.

[2] The above heat-resistant film, wherein the hard segment contained in the polyester-based elastomer comprises a polybutylene terephthalate unit, and the polyester-based elastomer has a melting point of 195 to 220°C.
[3] The above heat-resistant film, wherein the hard segment contained in the polyester-based elastomer comprises a polybutylene naphthalate unit, and the polyester-based elastomer has a melting point of 210 to 240°C.
[4] The above heat-resistant film, which is used for a protection film.
[5] An adhesive sheet comprising an adhesive on at least one surface of the above heat-resistant film.

### EFFECT OF THE INVENTION

The heat-resistant film of the present invention is made from a specific polyester-based elastomer. In particular, the heat-resistant film has excellent heat resistance and high expandability due to the inclusion of the soft segment according to the present invention.

### MODE FOR CARRYING OUT THE INVENTION

The heat-resistant film of the present invention is suitable mainly for a dicing tape for holding a semiconductor, dies, and the like in producing dies through dicing and singulation. Furthermore, the heat-resistant film of the present invention is capable of being subjected to a heat treatment in the step of coating the adhesive layer and the like, has sufficient expandability due to its excellent extensibility, and is applicable to a surface protection film that protects the surface provided with electrical conduction, decoration or the like in a plastic product, a glass product, a ceramic product, and the like. Moreover, the present invention can provide an adhesive sheet having an adhesive.
The heat-resistant film of the present invention has compounds, configurations, and the like described below.

<Polyester-based elastomer>

The polyester-based elastomer for the heat-resistant film of the present invention includes a hard segment including a polyester constituted from an aromatic dicarboxylic acid and an aliphatic diol or an alicyclic diol and a soft segment including mainly an aliphatic polycarbonate that are linked to each other.
The aromatic dicarboxylic acid that constitutes the polyester of the hard segment in the polyester-based elastomer may be a widely used common aromatic dicarboxylic acid. Specifically, the aromatic dicarboxylic acid is preferably a terephthalic acid or a naphthalenedicarboxylic acid. These compounds may be included as a main component of the aromatic dicarboxylic acid in the present invention.

Examples of other acid components include aromatic dicarboxylic acids such as diphenyldicarboxylic acid, isophthalic acid, and sodium 5-sulfoisophthalate; alicyclic dicarboxylic acids such as cyclohexanedicarboxylic acid, and tetrahydrophthalic anhydride; and those to which aliphatic dicarboxylic acids such as succinic acid, glutaric acid, adipic acid, azelaic acid, sebacic acid, dodecanedioic acid, dimer acid, and hydrogenated dimer acid are added. The aliphatic dicarboxylic acid is used within a range in which the melting point of the resin does not significantly decrease, and the amount thereof is less than 30 mol%, preferably less than 20 mol% of the total acid components.

The aliphatic diol or the alicyclic diol that constitutes the polyester of the hard segment is not particularly limited, but is preferably an alkylene glycol having 2 to 8 carbon atoms. Specific examples thereof include ethylene glycol, 1,3-propylene glycol, 1,4-butanediol, 1,6-hexanediol, and 1,4-cyclohexanedimethanol. Among there, 1,4-butanediol and 1,4-cyclohexanedimethanol are most preferable. These compounds may be included as a main component of the diol in the present invention.

Therefore, the polyester of the hard segment is preferably one composed mainly of butylene terephthalate units or butylene naphthalate units in terms of physical properties, moldability, and cost performance.

The aliphatic diol that constitutes the soft segment in the polyester-based elastomer for the heat-resistant film of the present invention is preferably a compound from which an aliphatic polycarbonate diol having a low melting point (for example, 70°C or lower) and a low glass transition temperature can be made. For example, an aliphatic polycarbonate diol constituted from 1,6-hexanediol is preferable due to its low glass transition temperature of about -60°C and a melting point of about 50°C, thereby enabling the obtained heat-resistant film to have extensibility at room temperature. An aliphatic polycarbonate diol obtained by copolymerizing the above-mentioned aliphatic polycarbonate diol, for example, with a suitable amount of 3-methyl-1,5-pentanediol, is also considered as a satisfactory aliphatic polycarbonate diol due to its lower melting point or amorphous structure, although the glass transition point is slightly increased compared with that of the above-mentioned aliphatic polycarbonate diol. Additionally, an aliphatic polycarbonate diol constituted from 1,9-nonanediol and 2-methyl-1,8-octanediol, for example, is also considered as a satisfactory aliphatic polycarbonate diol due to its melting point of about 30°C and a sufficiently low glass transition temperature of about -70°C.

These aliphatic polycarbonate diols may be copolymerized with a small amount of a copolymerization component such as another glycol, a dicarboxylic acid, an ester compound, and an ether compound. Examples of the copolymerization component include a glycol such as a dimer diol, a hydrogenated dimer diol, and a modified diol thereof; a dicarboxylic acid such as a dimer acid, and a hydrogenated dimer acid; a polyester or oligoester made from an aliphatic, aromatic, or alicyclic dicarboxylic acid and a glycol; a polyester or oligoester made from ε-caprolactone or the like; a polyalkylene glycol or oligoalkylene glycol such as polytetramethylene glycol, and polyoxyethylene glycol. The copolymerization component can be contained to such an extent that the effect of the aliphatic polycarbonate segment is not substantially lost. The aliphatic polycarbonate diol may be one mainly including an aliphatic diol residue having 2 to 12 carbon atoms, such as ethylene glycol, 1,3-propylene glycol, 1,4-butanediol, 1,5-pentanediol, 1,6-hexanediol, 1,8-octanediol, 2,2-dimethyl-1,3-propanediol, 3-methyl-1,5-pentanediol, 2,4-diethyl-1,5-pentanediol, 1,9-nonanediol, and 2-methyl-1,8-octanediol. In particular, as the aliphatic polycarbonate diol, an aliphatic polycarbonate diol mainly including an aliphatic diol residue having 5 to 12 carbon atoms is preferable from the viewpoints of heat resistance and extensibility. These components may be used alone or in combination of two or more as needed.

A copolymerization component such as a polyalkylene glycol such as polyethylene glycol and polyoxytetramethylene glycol, and a polyester such as polycaprolactone and polybutylene adipate may be introduced into the soft segment to such an extent that the effect of the invention is not lost.

In the polyester-based elastomer used in the heat-resistant film of the present invention, the mass ratio of the hard segment including a polyester constituted from an aromatic dicarboxylic acid and an aliphatic diol or an alicyclic diol and the soft segment including an aliphatic polycarbonate and a copolymerization component contained as needed is typically in the range of the hard segment:the soft segment = 40:60 to 80:20 because the extensibility may decrease with an increase in mass ratio of the hard segment, and the heat resistance may decrease with an increase in the mass ratio of the soft segment. Preferably, the weight ratio of the hard segment contained in the polyester-based elastomer is greater than the weight ratio of the soft segment, and the weight ratio of the hard segment contained in the polyester-based elastomer exceeds 50%. The weight ratio is, for example, in the range of the hard segment:the soft segment = 50.1:49.9 to 70:30, and preferably in the range of the hard segment:the soft segment = 55:45 to 75:25. In one embodiment, the weight ratio is in the range of the hard segment:the soft segment = 55:45 to 70:30.

In the polyester-based elastomer for the heat-resistant film of the present invention, the hard segment including a polyester made from an aromatic dicarboxylic acid and an aliphatic diol or an alicyclic diol and the soft segment mainly including an aliphatic polycarbonate are preferably linked in a state in which the units constituting the hard segment and/or the soft segment are linked directly via an ester bond or a carbonate bond.

The hard segment and the soft segment in the polyester-based elastomer are preferably linked with a chain extender such as an isocyanate compound. In this case, the polyester that constitutes the hard segment, the polycarbonate that constitutes the soft segment, and the copolymerization component using as needed are, under melting, repeatedly subjected to transesterification and depolymerization in a predetermined period to prepare a reactant (hereinafter may be referred to as a "block reactant"). With respect to 100 parts by mass of the block reactant, a polycarbodiimide compound is preferably contained in an amount of 0.5 to 10 parts by mass, for example, 0.5 to 6 parts by mass, and more preferably 1.0 to 3.0 parts by mass.

The above polycarbodiimide compound can be prepared, for example, by decarbonization of a diisocyanate compound. Examples of the diisocyanate compound include 4,4'-diphenylmethane diisocyanate, 4,4'-diphenyldimethylmethane diisocyanate, 1,3-phenylene diisocyanate, 1,4-phenylene diisocyanate, 2,4-tolylene diisocyanate, 2,6-tolylene diisocyanate, 1,5-naphthylene diisocyanate, hexamethylene diisocyanate, dicyclohexylmethane diisocyanate, cyclohexane-1,4-diisocyanate, xylylene diisocyanate, isophorone diisocyanate, methylcyclohexane diisocyanate, tetramethylxylylene diisocyanate, and 1,3,5-triisopropyl phenylene-2,4-diisocyanate. These compounds may be used alone, or two or more compounds may be copolymerized for use. The polycarbodiimide compound may have a branched structure and may have a functional group other than a carbodiimide group and an isocyanate group. The functional group can be introduced by means of copolymerization. The terminal isocyanate groups may be used without any modification, the terminal isocyanate groups may also be allowed to react to control the degree of polymerization, and part of the terminal isocyanate groups may also be blocked.

Among these polycarbodiimide compounds, an alicyclic polycarbodiimide made mainly from dicyclohexylmethane diisocyanate, cyclohexane-1,4-diisocyanate, isophorone diisocyanate, or the like is preferable. A polycarbodiimide compound having an isocyanate group on a terminal and having an isocyanate group content of about 0.5 to 4 mass% is preferable in terms of stability and easy handling. The isocyanate group content is more preferably about 1 to 3 mass%.

In particular, a polycarbodiimide compound derived from dicyclohexylmethane diisocyanate or isophorone diisocyanate and having an isocyanate group content of 0.5 to 4 mass% is preferable, and that having an isocyanate group content of 1 to 3 mass% are more preferable. The isocyanate group content can be measured by a standard method (a method in which a compound is dissolved in an amine and subjected to back titration with hydrochloric acid).

The number of carbodiimide groups in the carbodiimide compound is preferably 2 to 50 in terms of thermal stability, and more preferably 5 to 30. A polycarbodiimide compound having a degree of polymerization in the above range is solid at around room temperature. Therefore, the polycarbodiimide compound can be made into powder, whereby the compound is excellent in terms of workability and compatibility upon mixing with a polyester-based elastomer and is preferred in view of uniform reactivity and resistance to bleeding out. The number of carbodiimide groups is the number of carbodiimides in the polycarbodiimide compound and corresponds to a degree of polymerization in the case of a polycarbodiimide prepared from a diisocyanate compound. Usually, a polycarbodiimide is a mixture of molecules with various lengths, and thus the number of the carbodiimide groups is expressed by a mean value. The number of carbodiimide groups can also be measured using a standard method (a method in which a compound is dissolved in an amine, and subjected to back titration with hydrochloric acid) in the same manner as described above.

Using such a polycarbodiimide compound having an isocyanate group content of 0.5 to 4 mass% and the number of carbodiimide groups of 2 to 50 makes it possible to obtain a polyester-based elastomer having a MFR of 1 to 10 g/10 min. Therefore, using it makes it possible to suppress the occurrence of uneven ejection and the like in melt extrusion in film formation. The MFR can be measured in accordance with JIS K 7210 "Plastics-Determination of the melt mass-flow rate (MFR) and melt volume-flow rate (MVR) of thermoplastics".

Furthermore, a reactive compound having two or more glycidyl groups per molecule, a weight average molecular weight of 4,000 to 25,000, and an epoxy value of 400 to 780 equivalents/$10^6$ g can be used. When the reactive compound is used, the content of it is preferably 0.1 to 30 parts by mass, and more preferably 0.5 to 5 parts by mass.

The composition obtained by this formulation retains about the same reduced viscosity as before molding in film formation and the like, even when the composition is molded. As a result, the generation of foreign substances such as gel-like substances is suppressed. Furthermore, although the mechanism is not clear, using the composition makes it possible to increase the ratio F50/F25 of a stress F50 at an elongation of 50% to a stress F25 at an elongation of 25% increases, resulting in uniform extensibility.

In the heat-resistant film of the present invention, the ratio F50/F25 of a stress F50 at an elongation of 50% to a stress F25 at an elongation of 25% is 1.05 or more, and, for example, 2.0 or less. In one embodiment, the ratio F50/F25 may be 1.05 or more and 1.6 or less.

The ratio F50/F25 within the above range decreases defects such as wrinkles and distortion in stretching in one or multiple directions.

When the polyester-based elastomer, contained in the heat-resistant film of the present invention, in which the hard segment including a polyester constituted from an aromatic dicarboxylic acid and an aliphatic diol or an alicyclic diol, and the soft segment mainly including an aliphatic polycarbonate are linked to each other, has a low melting point, the heat resistance may reduce, and when the polyester-based elastomer has a high melting point, the extensibility may reduce. In one embodiment, the polyester-based elastomer may have a melting point of 195°C or higher. When the hard segment includes polybutylene terephthalate units, the polyester-based elastomer preferably has a melting point of 195 to 220°C. When the hard segment includes polybutylene naphthalate units, the polyester-based elastomer preferably has a melting point of 210 to 240°C.

The polyester-based elastomer may further contain known inorganic compound particles such as silica, talc, zeolite, and aluminum borate, and known organic compound particles such as polymethyl methacrylate, melamine formalin resin, melamine urea resin, and polyester resin insofar as they do not impair attaining the object of the invention. It should be noted that there is a concern about contamination due to bleeding by using organic slip agents, as exemplified by hydrocarbon-based slip agents such as liquid paraffin, paraffin wax, and synthetic polyethylene wax; aliphatic/higher alcohol-based slip agents such as stearic acid and stearyl alcohol; and fatty acid amide-based slip agents such as stearic acid amide, oleic acid amide, and erucic acid amide. Therefore, it is important that the amount of the organic slip agents extracted by Soxhlet extraction with chloroform in accordance with JIS K 6229 "Rubber-Determination of solvent extract (quantitative)" is 1 wt% or less, or that no organic slip agent is substantially contained. When the organic slip agents are contained, the amount of each organic slip agent extracted by the above method is preferably 0.5 wt% or less, and more preferably 0.1 wt% or less.

Raw materials for the preparation of polyester-based elastomer are not particularly limited and may be petroleum-derived materials, plant-derived materials, and the like. Plant-derived materials are preferable from an environmental point of view.

<Sheet formation>

The heat-resistant film of the present invention can be produced by forming a sheet by melt extrusion or the like using the polyester-based elastomer in which the hard segment including a polyester made from an aromatic dicarboxylic acid and an aliphatic diol or an alicyclic diol and the soft segment mainly including an aliphatic polycarbonate are linked to each other.

In the melt extrusion, a sheet-like material is extruded from a T-die through a uniaxial or biaxial screw extruder. The sheet-like material is solidified by cooling while being pressed with an air knife, an air chamber, a hard rubber roll, a steel belt, a metal roll, or the like on the surface of a metal roll in which cooling water or oil is circulating. Alternatively, the sheet-like material may be solidified by cooling while being sandwiched between steel belts. The above-mentioned sheet-like material may be a sheet-like material having a heterogeneous multilayer structure obtained by using a feed block or a multi-manifold. The sheet-like material can be uniaxially or biaxially stretched as needed. A high total stretch ratio may decrease extensibility, and a low total stretch ratio may increase thickness variation. Therefore, the total stretch ratio is preferably 3 to 12.

<Structure of heat-resistant film>

The heat-resistant film of the present invention may have a layer configuration of A (single layer), A/B, A/B/A, A/B/C, or the like by using a similar type of polyester-based elastomer, a different type of elastomer or polyester-based resin, different type of resin, and the like. Furthermore, another resin layer may be provided between the layers so as not to cause problems such as delamination.

In such a structure of the heat-resistant film, a low coefficient of static friction on at least one surface causes problems such as winding misalignment when the film is wound into a roll. Furthermore, a high coefficient of static friction causes remaining of wrinkles and the like. Therefore, the lower limit of the coefficient of static friction is preferably 0.10 or more, and more preferably 0.15 or more. The upper limit of the coefficient of static friction is preferably 0.9 or less. Especially in an application of the heat-resistant film to a dicing tape for semiconductor manufacturing process, the upper limit of the coefficient of static friction is more preferably 0.5 or less; otherwise the film may not be uniformly expanded in the expansion step.

<Thickness of heat-resistant film>

Depending on the method of use of the heat-resistant film of the present invention, a small total thickness may cause reduced stiffness, and a large total thickness may cause a problem in handleability. Especially in an application of the heat-resistant film to a dicing tape for semiconductor manufacturing process, defects that occur during a dicing step may cause breakage of the film and/or uneven expandability. Therefore, the total thickness of the heat-resistant film is preferably 60 $\mu$m or more, and more preferably 80 $\mu$m or more. The total thickness of the heat-resistant film is preferably 180 $\mu$m or less from the viewpoint of handleability.

A high elastic modulus of the thermoplastic resin film of the present invention decreases extensibility, and a low elastic modulus of the thermoplastic resin film decreases stiffness. Therefore, the thermoplastic resin film preferably has an elastic modulus of 30 to 500 MPa, and more preferably 30 to 100 MPa. The thermoplastic resin film may have an elongation at break of 200 to 700%, for example, 350 to 700%.

<Adhesive>

In one embodiment, an adhesive sheet having an adhesive on at least one surface of the heat-resistant film of the present invention is provided. Examples of the adhesive used in the adhesive sheet of the present invention include a (meth)acrylic adhesive, a silicone adhesive, a urethane adhesive, an olefin adhesive, and a styrene adhesive. The adhesive can be selected according to a subject to which it is applied, such as a surface protection film that protects the state of a surface provided with electrical conduction, decoration, or the like in a plastic product, a glass product, a ceramic product, and the like. For a dicing tape for holding a wafer, the dies, and the like in producing dies through dicing and singulation in a semiconductor manufacturing process, a (meth)acrylic adhesive is preferable due to its easily adjustable the adhesive strength.

The thickness of an adhesive layer formed of the above-mentioned adhesive is not particularly limited. When the heat-resistant film of the present invention is applied to, for example, (i) a dicing tape for holding a wafer, dies, and the like in producing dies through dicing and singulation in a semiconductor production process or (ii) a surface protection film that protects a surface provided with electrical conduction, decoration, or the like in a plastic product, a glass product, a ceramic product, and the like, the thickness of the adhesive layer is preferably 1 to 50 $\mu$m, and more preferably 3 to 30 $\mu$m from the viewpoints of adhesive strength, uniformity in thickness of the adhesive layer, and the like.

EXAMPLES

Hereinafter, the present invention will be described in more detail with reference to Examples. The present invention is not limited to the Examples described below, and can be carried out with appropriate modifications being made within the scope of the gist of the present invention described above and below. Such modifications are included in the technical scope of the invention.

Methods for evaluating physical properties in Examples are as follows.

(1) Number average molecular weight

An aliphatic polycarbonate diol sample was dissolved in deuterated chloroform (CDCl$_3$), and the amount of the terminal group was calculated by measuring the solution sample with H-NMR. The number average molecular weight was determined by the following equation:

$$\text{Number average molecular weight} = 1{,}000{,}000/((\text{terminal group amount (equivalents/ton)})/2).$$

(2) Reduced viscosity

In accordance with JIS K 7367-5: 1998 "Plastics-Determination of the viscosity of polymers in dilute solution using capillary viscometers-", a mixed solvent of phenol/tetrachloroethane = 60/40 (mass%) was used, and the viscosity number obtained by measurement with an Ostwald viscometer was taken as the reduced viscosity.

(3) Tm (melting point)

In accordance with JIS K 7121:1987 "Testing Methods for Transition Temperatures of Plastics", the melting peak temperature in the curve obtained by DSC (Differential Scanning Calorimetry) was used.

(4) Soft (segment) content

A sample was dissolved in a solvent (deuterated chloroform/trifluoroacetic acid = 85/15 vol%) at a concentration of 3 to 5 vol%, and then, the resultant solution was subjected to proton NMR measurement at 25°C using a Fourier transform nuclear magnetic resonance device (AVANCE-NEO500 manufactured by BRUKER, Germany). The mass ratio between the hard segment and the soft segment was calculated from the signal intensity ratio of methylene peaks adjacent to various oxygens in the molecular structure.

(5) Film thickness

The film thickness was determined in accordance with JIS K 7130:1999 "Plastics-Film and sheeting-Determination of thickness (method A)".

(6) Strength, elongation, elastic modulus, F25, and F50

In accordance with JIS K 7127:1999 "Plastics-Determination of tensile properties-", the strength, the elongation, and the elastic modulus were determined from the tensile strength, the tensile elongation at break, and the tensile elastic modulus. Specified strains were set to 25% and 50%, and the tensile stresses at 25% and 50% strains were taken as F25 and F50, respectively. The index of expandability is indicated by a stress ratio F50/F25 at the above specified strains.

(7) Coating property

To a solution containing an acrylic copolymer (weight average molecular weight 500,000) prepared by copolymerizing butyl acrylate/acrylic acid = 90/10 in a toluene solution by a standard method were added 80 parts by weight of commercially available dipentaerythritol hexaacrylate "KAYARAD DPHA: manufactured by Nippon Kayaku Co., Ltd.", 5 parts by weight of a photopolymerization initiator "Omnirad 184: manufactured by IGM Resins R.V", and 5 parts by weight of a polyisocyanate compound "Coronate L: manufactured by Tosoh Corporation" to prepare an adhesive solution. The adhesive solution was applied to a commercially available release film "E7002: manufactured by TOYOBO Co., Ltd." so as to have an adhesive thickness of about 10 $\mu$m. Then, the release film was bonded to a heat-resistant film (Example) of the present invention or a general-purpose film (Comparative Example) to produce an adhesive sheet. The adhesive sheet thus produced was evaluated by the following items.

Very good: No curl occurred in a cut sheet product of the adhesive sheet.
Good: Curl occurred in a cut sheet product of the adhesive sheet but could be controlled by adjusting the tension of the sheet-like material.
Poor: Curl occurred in a cut sheet product of the adhesive sheet and was difficult to control even by adjusting the tension of the sheet-like material.
Very poor: It was difficult to adjust the tension of the sheet-like material bonding the adhesive and the obtained film, and there was unevenness in adhesive thickness in a cut sheet product.

(8) Expandability

The adhesive sheet was fixed to a 6-inch dicing frame with a double-sided tape, and a center point and concentric circles with a diameter of 50 mm and a diameter of 100 mm passing through the center point were drawn. Then, the adhesive sheet was expanded with an expander (stage: temperature of 30°C, lifting speed of 50 mm/min, holding for 60 seconds) so as to have a predetermined elongation with respect to the inner diameter of the dicing frame, and elongations were measured at 45-degree pitches with respect to the concentric circle. The following evaluation was performed from the elongations measured. The predetermined elongation is obtained by the following equation:

$$\text{Elongation (\%)} = (\text{stage movement distance} * 2) / \text{frame inner diameter} * 100.$$

Very good: Elongations in all the directions reached 65% or more of the predetermined elongation, and the maximum difference was less than 2%.
Good: Elongations in all the directions reached 65% or more of the predetermined elongation, but the maximum difference was 2 to 5%.
Poor: Elongations in some directions were 50 to 65% of the predetermined elongation, and the maximum difference was 2 to 5%.
Very poor: Elongations in some directions were less than 50% of the predetermined elongation, or the maximum difference was 5% or more.

(9) Heat resistance

In accordance with JIS K 7206:1999 "Plastics-Thermoplastic materials-Determination of Vicat softening temperature (method A120)", the following evaluation was performed on samples with a plate thickness of 3 mm prepared with a pressing machine from the resins obtained in the following Examples and Comparative Examples.

Very good: Vicat softening point of 180°C or higher
Good: Vicat softening point of 170 to 180°C
Poor: Vicat softening point of 160 to 170°C
Very poor: Vicat softening point of 160°C or lower

Next, the present invention will be described in even more detail with reference to Examples and Comparative Examples, but the present invention is not limited to the following examples.

<Examples 1 and 2>

A mixture of commercially available 1,6-hexanediol type aliphatic polycarbonate diol (molecular weight 2000) and diphenyl carbonate was allowed to react at a temperature of 205°C and a pressure of 130 Pa for 2 hours to obtain a preparation (number average molecular weight 10,000). The preparation and PBT (polybutylene terephthalate) were subjected to polycondensation at elevated temperature and reduced pressure to obtain a resin having a predetermined soft segment mass ratio shown in Table 1.
The obtained resin was used as a resin for layer A. A pellet-shaped MB (masterbatch) containing 15 wt% of commercially available spherical silica (average particle size 12 $\mu$m) based on the same resin as the obtained resin was prepared, and a resin (for layer B) was prepared from the masterbatch so as to have a spherical silica content of 7,500 ppm. The resin (for layer A) and the resin (for layer B) were extruded from a T-die through an extruder such that the film thickness of the structure A was 10% of the total thickness and the layer configuration had the structure A/B. The extruded resins were pressed against a cooling roll with an air knife, and then edge trimming was performed in the process to produce a heat-resistant film of each of Examples 1 and 2 with a total thickness of 100 $\mu$m, which was a roll with a width of 650 mm and a winding length of 1,000 m.
In the above Examples, although sheet formation was performed at about a 10°C higher temperature than the melting point for about 4 to 5 hours, no abnormal pressure was observed during extrusion or discharge. Table 1 shows the properties of the resins used and the evaluation results of the heat-resistant films and the rolls.

<Comparative Examples 1 and 2>

In each of Comparative Examples 1 and 2, a film was produced in the same manner as in Example 1, except that a resin having the characteristics shown in Table 1 was used. Table 1 shows the physical properties of the produced films.

<Examples 3 and 4>

A resin was obtained in the same manner as in Example 1, except that PBN (polybutylene naphthalate) was used for polycondensation with a preparation (number average molecular weight 10,000) obtained by reacting a mixture of commercially available 1,6-hexanediol type aliphatic polycarbonate diol (molecular weight 2000) and diphenyl carbonate at a temperature of 205°C and a pressure of 130 Pa for 2 hours.
Furthermore, in the same manner as in Example 1, a film was formed such that the film thickness of the structure A was 10% of the total thickness and the layer configuration had the structure A/B, and a roll of a heat-resistant film with a total thickness of 100 $\mu$m, a width of 650 mm, and a winding length of 1,000 m was produced.
In the above Examples, although sheet formation was performed at about a 10°C higher temperature than the melting point for about 4 to 5 hours, no abnormal pressure was observed during extrusion or discharge. Table 1 shows the properties of the resins used and the evaluation results of the heat-resistant films and the rolls.

<Comparative Examples 3 and 4>

In each of Comparative Examples 3 and 4, a film was produced in the same manner as in Example 3, except that a resin having the conditions shown in Table 1 was used. Table 1 shows the physical properties of the produced films.

[Table 1]

| | Resin | | | Heat-resistant film | | | | Coating property | Expandability | | | Heat resistance |
|---|---|---|---|---|---|---|---|---|---|---|---|---|
| | Reduced viscosity dl/g | Tm °C | Soft wt% | Strength MPa | Elongation % | Elastic modulus MPa | F50/F25 | | Elongation 20% | Elongation 30% | Elongation 40% | |
| Example 1 | 1.210 | 207 | 30.0 | 82 | 510 | 250 | 1.11 | Good | Very good | Very good | Good | Very good |
| Example 2 | 1.100 | 200 | 43.0 | 50 | 600 | 115 | 1.05 | Good | Very good | Very good | Good | Good |
| Example 3 | 1.200 | 225 | 30.0 | 70 | 500 | 290 | 1.06 | Good | Very good | Good | Good | Very good |
| Example 4 | 1.150 | 215 | 43.0 | 54 | 580 | 130 | 1.07 | Good | Very good | Good | Good | Good |
| Comparative Example 1 | 1.230 | 215 | 20.0 | 73 | 330 | 520 | 0.68 | Very good | Very good | Poor | Very poor | Very good |
| Comparative Example 2 | 1.130 | 190 | 50.0 | 46 | 650 | 96 | 1.06 | Poor | Very good | Good | Good | Very poor |
| Comparative Example 3 | 1.230 | 238 | 20.0 | 54 | 230 | 740 | 0.66 | Very good | Good | Poor | Very poor | Very good |
| Comparative Example 4 | 1.120 | 196 | 50.0 | 48 | 710 | 113 | 1.07 | Good | Very good | Very good | Good | Poor |

The adhesive sheet of the present invention is a heat-resistant film using a polyester-based elastomer as a resin in which a hard segment including a polyester made from an aromatic dicarboxylic acid and an aliphatic diol or an alicyclic diol, and a soft segment mainly including an aliphatic polycarbonate are linked to each other. In the Examples, the tension can be easily adjusted in coating and the like of the adhesive, and therefore, unevenness in thickness of the adhesive and curl of the cut sheet product due to bonding of the release film are reduced. Furthermore, in terms of the expandability, uniform extension can be achieved even at a high elongation, and high heat resistance as one of the features of the polyester-based elastomer is also maintained.

<Examples 5 to 12>

A mixture of commercially available 1,6-hexanediol type aliphatic polycarbonate diol (molecular weight 2000) and diphenyl carbonate was allowed to react at a temperature of 205°C and a pressure of 130 Pa for 2 hours to obtain a preparation (number average molecular weight 10,000) which was described in Examples 1 to 4. (i) The preparation and (ii) PBT (polybutylene terephthalate) or PBN (polybutylene naphthalate) were subjected to polycondensation at elevated temperature and reduced pressure to obtain a resin having a predetermined soft segment mass ratio.
A heat-resistant film was produced in the same manner as in Example 1, except that a pellet-shaped MB (masterbatch) containing 15 wt% of commercially available spherical silica (average particle size 12 $\mu$m) based on the same resin as the obtained resin (for layer A) was prepared, a resin (for layer B) was prepared from the masterbatch so as to have a spherical silica content of 7,500 ppm, and a carbodiimide compound ("Carbodilite LA-1") was side-fed in a predetermined amount during extrusion of the resin for the layer A and the resin for the layer B. Specifically, the resin for layer A and the resin for layer B were extruded from a T-die through an extruder such that the film thickness of the structure A was 10% of the total thickness and the layer configuration had the structure A/B. The extruded resins were pressed against a cooling roll with an air knife, and then edge trimming was performed in the process to produce a heat-resistant film of each of Examples 5 to 12 with a total thickness of 100 $\mu$m, which was a roll with a width of 650 mm and a winding length of 1,000 m.
Table 2 shows the properties of the resins and the evaluation results of the sheet-like materials of the resins and the rolls of the above Examples 5 to 12.

[Table 2]

| | | Resin | | Heat-resistant film | | | | Coating property | Expandability | | | Heat resistance |
|---|---|---|---|---|---|---|---|---|---|---|---|---|
| | Base | Carbodiimide phr | Reduced viscosity dl/g | Strength MPa | Elongation % | Elastic modulus MPa | F50/F25 | | Elongation 20% | Elongation 30% | Elongation 40% | |
| Example 5 | Example 1 | 5.0 | 1.640 | 75 | 450 | 210 | 1.32 | Good | Very good | Very good | Very good | Very good |
| Example 6 | Example 1 | 4.0 | 1.661 | 71 | 450 | 210 | 1.32 | Good | Very good | Very good | Very good | Very good |
| Example 7 | Example 1 | 3.0 | 1.659 | 63 | 460 | 213 | 1.29 | Good | Very good | Very good | Very good | Very good |
| Example 8 | Example 1 | 2.0 | 1.634 | 60 | 470 | 221 | 1.18 | Good | Very good | Very good | Very good | Very good |
| Example 9 | Example 2 | 4.0 | 2.100 | 80 | 400 | 100 | 1.47 | Good | Very good | Very good | Very good | Very good |
| Example 10 | Example 2 | 2.0 | 1.839 | 76 | 430 | 118 | 1.40 | Good | Very good | Very good | Very good | Very good |
| Example 11 | Example 3 | 2.0 | 1.650 | 63 | 460 | 270 | 1.22 | Good | Very good | Very good | Good | Very good |
| Example 12 | Example 4 | 2.0 | 1.743 | 53 | 660 | 115 | 1.40 | Good | Very good | Very good | Very good | Very good |

The adhesive sheet of the present invention is a heat-resistant film using a polyester-based elastomer as a resin in which a hard segment including a polyester made from an aromatic dicarboxylic acid and an aliphatic diol or an alicyclic diol, and a soft segment mainly including an aliphatic polycarbonate are linked to each other. Although the manifestation mechanism is unknown, the addition of the polycarbodiimide compound improves the expandability as well as increases the reduced viscosity corresponding to the molecular weight, and an occasion of whitening on the cooling roll when forming a heat-resistant film reduces, thereby facilitating the temperature control of the cooling roll.

For each of Examples 1 to 12 and Comparative Examples 1 to 4, about 2 g of a sample was collected, cut, and subjected to Soxhlet extraction with chloroform (extraction for 4 hours). It was confirmed that the content of the extract was 0.6 wt% or less.

INDUSTRIAL APPLICABILITY

The adhesive sheet of the present invention is a heat-resistant film formed of a polyester-based elastomer, and has high heat resistance as one of its features. By containing the prescribed soft segment in an appropriate amount in the polyester-based elastomer, the stability can be ensured even in the processing steps such as coating, and uniform extension can be obtained even at a high elongation in terms of expandability. Therefore, the heat-resistant film is suitable for use as a surface protection film that protects the state of a surface provided with electrical conduction, decoration, or the like in a plastic product, a glass product, a ceramic product, and the like, and particularly suitable for use as a surface protection film or a dicing tape in semiconductor processing.

**Claims**

1. A heat-resistant film comprising a thermoplastic resin, wherein

   the thermoplastic resin is a polyester-based elastomer comprising a hard segment and a soft segment that are linked to each other,
   the hard segment comprises a polyester unit constituted from (i) an aromatic dicarboxylic acid and (ii) an aliphatic diol or an alicyclic diol,
   the soft segment is constituted mainly from an aliphatic polycarbonate,
   a weight ratio of the hard segment contained in the polyester-based elastomer exceeds 50%, and
   the film comprising the thermoplastic resin has an elastic modulus of 30 to 500 MPa, an elongation at break of 200 to 700%, and a ratio F50/F25 of 1.05 or more, the ratio F50/F25 being a ratio of a stress F50 at an elongation of 50% to a stress F25 at an elongation of 25%.

2. The heat-resistant film according to claim 1, wherein the hard segment contained in the polyester-based elastomer comprises a polybutylene terephthalate unit, and the polyester-based elastomer has a melting point of 195 to 220°C.

3. The heat-resistant film according to claim 1, wherein the hard segment contained in the polyester-based elastomer comprises a polybutylene naphthalate unit, and the polyester-based elastomer has a melting point of 210 to 240°C.

4. The heat-resistant film according to any one of claims 1 to 3, which is used for a protection film.

5. An adhesive sheet comprising an adhesive on at least one surface of the heat-resistant film according to any one of claims 1 to 3.

<table>
<tr><td align="center">**INTERNATIONAL SEARCH REPORT**</td><td colspan="2">International application No.<br>PCT/JP2021/019791</td></tr>
</table>

**A. CLASSIFICATION OF SUBJECT MATTER**
Int.Cl. B32B27/36(2006.01)i, C08J5/18(2006.01)i, H01L21/301(2006.01)i,
C09J7/25(2018.01)i, C09J7/38(2018.01)i, C08G63/64(2006.01)i
FI: C08J5/18CFD, H01L21/78M, C08G63/64, B32B27/36, C09J7/38, C09J7/25
According to International Patent Classification (IPC) or to both national classification and IPC

**B. FIELDS SEARCHED**

Minimum documentation searched (classification system followed by classification symbols)
Int.Cl. B32B27/36, C08J5/18, H01L21/301, C09J7/25, C09J7/38, C08G63/64

Documentation searched other than minimum documentation to the extent that such documents are included in the fields searched
| | |
|---|---|
| Published examined utility model applications of Japan | 1922-1996 |
| Published unexamined utility model applications of Japan | 1971-2021 |
| Registered utility model specifications of Japan | 1996-2021 |
| Published registered utility model applications of Japan | 1994-2021 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y | JP 2014-47222 A (TOYOBO CO., LTD.) 17 March 2014<br>(2014-03-17), claims, examples (example 2) | 1-3<br>4, 5 |
| Y | JP 2013-194187 A (FURUKAWA ELECTRIC CO., LTD.) 30<br>September 2013 (2013-09-30), abstract, etc. | 4, 5 |
| A | WO 2008/093574 A1 (TOYOBO CO., LTD.) 07 August 2008<br>(2008-08-07), entire text | 1-5 |
| A | WO 2007/072748 A1 (TOYOBO CO., LTD.) 28 June 2007<br>(2007-06-28), entire text | 1-5 |
| A | WO 2013/042167 A1 (TOYO TIRE & RUBBER CO., LTD.) 28<br>March 2013 (2013-03-28), entire text | 1-5 |

☒ Further documents are listed in the continuation of Box C.     ☒ See patent family annex.

| | |
|---|---|
| *    Special categories of cited documents:<br>"A"  document defining the general state of the art which is not considered<br>     to be of particular relevance<br>"E"  earlier application or patent but published on or after the international<br>     filing date<br>"L"  document which may throw doubts on priority claim(s) or which is<br>     cited to establish the publication date of another citation or other<br>     special reason (as specified)<br>"O"  document referring to an oral disclosure, use, exhibition or other means<br>"P"  document published prior to the international filing date but later than<br>     the priority date claimed | "T"  later document published after the international filing date or priority<br>     date and not in conflict with the application but cited to understand<br>     the principle or theory underlying the invention<br>"X"  document of particular relevance; the claimed invention cannot be<br>     considered novel or cannot be considered to involve an inventive<br>     step when the document is taken alone<br>"Y"  document of particular relevance; the claimed invention cannot be<br>     considered to involve an inventive step when the document is<br>     combined with one or more other such documents, such combination<br>     being obvious to a person skilled in the art<br>"&"  document member of the same patent family |

| Date of the actual completion of the international search<br>    25 June 2021 | Date of mailing of the international search report<br>    13 July 2021 |
|---|---|
| Name and mailing address of the ISA/<br>    Japan Patent Office<br>    3-4-3, Kasumigaseki, Chiyoda-ku,<br>    Tokyo 100-8915, Japan | Authorized officer<br><br><br>Telephone No. |

Form PCT/ISA/210 (second sheet) (January 2015)

**INTERNATIONAL SEARCH REPORT**

| International application No. |
| --- |
| PCT/JP2021/019791 |

C (Continuation).    DOCUMENTS CONSIDERED TO BE RELEVANT

| Category* | Citation of document, with indication, where appropriate, of the relevant passages | Relevant to claim No. |
| --- | --- | --- |
| A | WO 2012/018099 A1 (TEIJIN CHEMICALS LTD.) 09 February 2012 (2012-02-09), entire text | 1-5 |

Form PCT/ISA/210 (second sheet) (January 2015)

INTERNATIONAL SEARCH REPORT
Information on patent family members

International application No.

PCT/JP2021/019791

| | | |
|---|---|---|
| JP 2014-47222 A | 17 March 2014 | (Family: none) |
| JP 2013-194187 A | 30 September 2013 | (Family: none) |
| WO 2008/093574 A1 | 07 August 2008 | US 2010/0041858 A1<br>entire text |
| WO 2007/072748 A1 | 28 June 2007 | US 2009/0203871 A1<br>entire text |
| WO 2013/042167 A1 | 28 March 2013 | US 2014/0238570 A1<br>entire text |
| WO 2012/018099 A1 | 09 February 2012 | US 2013/0129990 A1<br>entire text |

Form PCT/ISA/210 (patent family annex) (January 2015)

**EP 4 163 112 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009094418 A
- JP 2003092273 A
- JP 2017034618 A